# EUROPEAN PATENT APPLICATION

(11) **EP 2 244 341 A1**
(43) Date of publication of application: **27.10.2010**
(21) Application number: 09708507.0
(22) Date of filing: 03.02.2009
(51) Int. Cl.: H01S 5/12, H01S 5/065, H01S 5/125

(54) **LASER DEVICE AND LASER DEVICE CONTROL DATA**

(30) Priority: 05.02.2008 JP 2008025410
(71) Applicant: Eudyna Devices Inc., Yamanashi 409-3883 (JP)
(72) Inventor: TANAKA, Hirokazu, Nakakoma-gun Yamanashi 409-3883 (JP); ISHIKAWA, Tsutomu, Nakakoma-gun Yamanashi 409-3883 (JP); MACHIDA, Toyotoshi, Nakakoma-gun Yamanashi 409-3883 (JP)
(74) Representative: Fenlon, Christine Lesley
(86) International application number: PCT/JP2009/051763
(87) International publication number: WO 2009/099050

(57) **Abstract**

A laser device includes a resonator having a gain region, a first wavelength selection portion and a second wavelength selection portion, the first wavelength selection portion having a periodical peak in wavelength characteristics, the second wavelength selection portion having a periodical peak in wavelength characteristics in a wavelength range smaller than a variable range of an oscillation wavelength at a period different from the first wavelength selection portion and having a peak wavelength shift by a refractive index changing thereof, the oscillation wavelength selected with a single direction changing of a refractive index of the second wavelength selection portion changing in a single direction in a same wavelength range; a storing portion storing a value selected from an extent over two adjacent ranges of the plurality of the ranges as a setting value of a refractive index of the second wavelength selection portion for selecting an oscillation wavelength; and a controller giving the setting value stored in the storing portion to the resonator.

## Description

### TECHNICAL FIELD

This invention generally relates to a laser device and a laser device control data.

### BACKGROUND ART

A tunable laser having a wavelength selection portion in a resonator and selecting outputting wavelengths is known. For example, Patent Document 1 discloses a tunable laser having a CSG-DBR (Chirped Sampled Grating Distributed Bragg Reflector) region and a SG-DFB (Sampled Grating Distributed Feedback) region.

In the CSG-DBR region, a reflection spectrum has a periodical peak only in a limited wavelength range. A peak period of a reflection spectrum of the SG-DFB region is different from that of the CSG-DBR region. This allows vernier effect. That is, a wavelength having the largest intensity is selected from wavelengths where the peaks overlap with each other.
Patent Document 1: Japanese Patent Application Publication No. 2007-048988

### DISCLOSURE OF THE INVENTION

### PROBLEMS TO BE SOLVED BY THE INVENTION

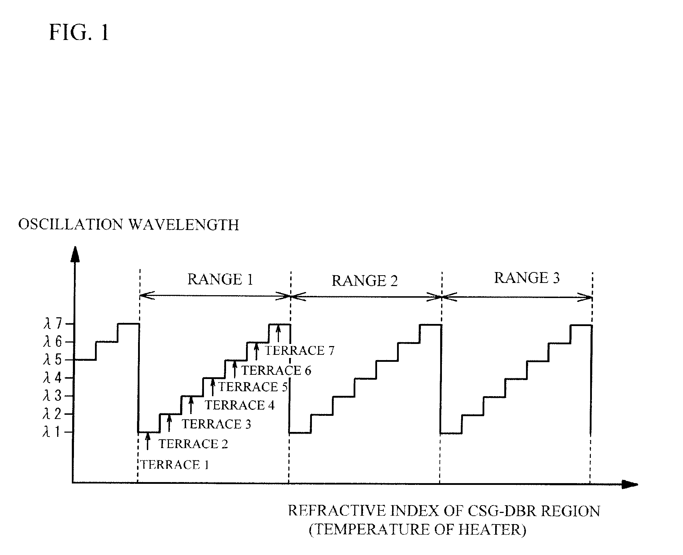

FIG. 1 illustrates an example of a relation between a change of refractive index and an oscillation wavelength of a CSG-DBR region. FIG. 1 illustrates characteristics in a case where temperature of each heater is changed with a temperature relation between a plurality of heaters on the CSG-DBR region being kept fixed. In concrete, FIG. 1 illustrates characteristics in a case where changing amount of temperature of each heater is equal to each other and changing amount of refractive index of regions according to each heater is equal to each other.

In the following description, a case where the refractive index of the CSG-DBR region is changed is a case where the changing amount of refractive index of regions according to each heater is equal to each other unless there is a particular reference.

In FIG. 1, a flat terrace part is a wavelength at which the tunable laser can oscillate. A width of each terrace corresponds to a peak interval of wavelength characteristics of the SG-DFB region. The oscillation wavelength changes in a single direction with respect to the changing of the refractive index of the CSG-DBR region. In FIG. 1, the oscillation wavelength changes toward long wavelength side with an increase of the refraction index of the CSG-DBR region.

When the peak interval of the reflection spectrum of the CSG-DBR region is reduced, it is possible to select a next wavelength by small refractive index changing. In this case, however, the interval of selected wavelength peak is reduced with the vernier effect simultaneously. And so, the periodical peak of the reflection spectrum of the CSG-DBR region is limited to a given wavelength range, as described above. Wavelengths other than the desired oscillation wavelength are excluded.

When the periodical peak of the reflection spectrum of the CSG-DBR region is limited to the given wavelength range, wavelength selectable ranges are, for example, limited to λ1 to λ7. A plurality of sets of the wavelength selectable ranges λ1 to λ7 appear periodically and continuously, because the wavelength selection with the vernier effect is recurrent. The characteristics of FIG. 1 appears in a case where a plurality of wavelength selection portions having different wavelength characteristics and a portion limiting an oscillation wavelength range are provided, as well as the case where the SG-DFB region and the CSG-DBR region are provided.

The tunable laser operates based on a setting value from a look-up table. The look-up table is made by observing a desirable outputting wavelength with a high accuracy wavelength meter at a shipping test and obtaining a setting value. Generally, a single range, in which a selected wavelength changes in a single direction with respect to the refractive index changing of the CSG-DBR region, is selected such as a range 1, 2 or 3 of FIG. 1, in the obtaining operation of the setting value. And, a setting value according to the λ1 to λ7 in the range is obtained.

There is a demand for reducing electrical power consumption of the tunable laser. It is, however, not possible to reduce the electrical power consumption of a conventional laser.

The present invention has an object to provide a laser device and a laser device control data reducing electrical power consumption.

### MEANS FOR SOLVING THE PROBLEMS

A laser device in accordance with the present invention is characterized by including a resonator having a gain region, a first wavelength selection portion and a second wavelength selection portion, the first wavelength selection portion having a periodical peak in wavelength characteristics, the second wavelength selection portion having a periodical peak in wavelength characteristics in a wavelength range smaller than a variable range of an oscillation wavelength at a period different from the first wavelength selection portion and having a peak wavelength shift by a refractive index changing thereof, the oscillation wavelength selected with a single direction changing of a refractive index of the second wavelength selection portion changing in a single direction in a same wavelength range; a storing portion storing a value selected from an extent over two adjacent ranges of the plurality of the ranges as a setting value of a refractive index of the second wavelength selection portion for selecting an oscillation wavelength; and a controller giving the setting value stored in the storing portion to the resonator. In the laser device of the present invention, electrical power consumption for changing refractive index of the second wavelength selection portion is restrained because a setting value of refractive index of the second wavelength selection portion from adjacent two ranges.

The storing portion may store a value selected within a range from an oscillation wavelength selected in a condition that the refractive of the second wavelength selection portion is not changed to a wavelength equal to the oscillation wavelength in the adjacent range. In this case, the electrical power consumption of the second wavelength selection portion, compared to a case where a setting value is selected within each range.

The storing portion may store a value selected within a range from an oscillation wavelength adjacent to another oscillation wavelength selected in a condition that the refractive of the second wavelength selection portion is not changed to a wavelength equal to the another oscillation wavelength in the adjacent range. In this case, the electrical power consumption of the second wavelength selection portion, compared to a case where a setting value is selected within each range.

A setting value of a refractive index of the second wavelength selection portion may be temperature of the second wavelength selection portion or current provided to the second wavelength selection portion. The storing portion may store a setting value of a refractive index of the second wavelength selection portion with respect to each desired wavelength.

A laser device control data in accordance with the present invention is a control data of a laser device having a gain region, a first wavelength selection portion and a second wavelength selection portion, the first wavelength selection portion having a periodical peak in wavelength characteristics, the second wavelength selection portion having a periodical peak in wavelength characteristics in a wavelength range smaller than a variable range of an oscillation wavelength at a period different from the first wavelength selection portion and having a peak wavelength shift by a refractive index changing thereof, the oscillation wavelength selected with a single direction changing of a refractive index of the second wavelength selection portion changing in a single direction in a same wavelength range, **characterized in that** the control data includes a setting value for determining a refractive index of the second wavelength selection portion according to an oscillation wavelength to be attained so that an extent from a maximum of the refractive index to a minimum of the refractive index is over the plurality of the ranges.

A setting value of a refractive index of the second wavelength selection portion may be temperature of the second wavelength selection portion or current provided to the second wavelength selection portion.

### EFFECTS OF THE INVENTION

In accordance with the present invention, it is possible to provide a laser device and a laser device control data reducing electrical power consumption.

### BRIEF DESCRIPTION OF THE DRAWINGS

FIG. 1 illustrates an example of a relation between a refractive index and an oscillation wavelength of a CSG-LBR region;
FIG. 2 illustrates a schematic view of a tunable laser in accordance with a first embodiment of the present invention and a laser device having the tunable laser;
FIG. 3 illustrates an example of a look-up table 51;
FIG. 4 illustrates an oscillation wavelength with respect to refractive index changing of the CSG-DBR region;
FIG. 5 illustrates a schematic view of a tunable laser in accordance with a second embodiment of the present invention; and
FIG. 6 illustrates a schematic view of a tunable laser in accordance with a third embodiment of the present invention.

### BEST MODES FOR CARRYING OUT THE INVENTION

A description will be given of a best mode for carrying the present invention.

### (First Embodiment)

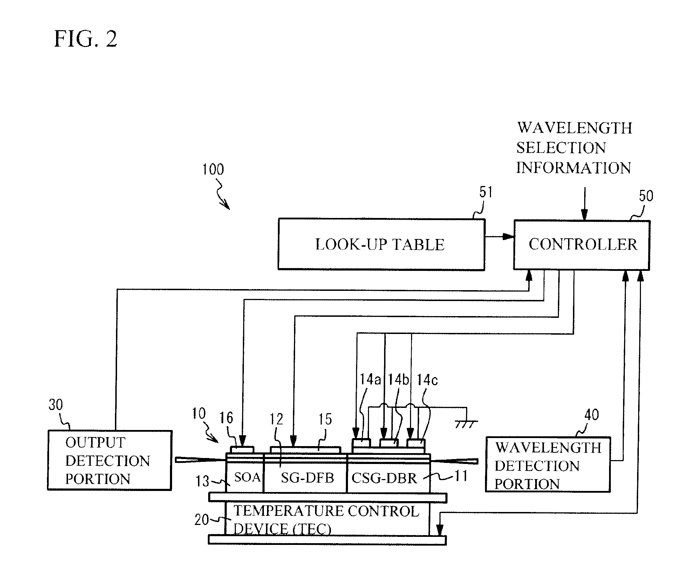

FIG. 2 illustrates a schematic view of a tunable laser 10 in accordance with a first embodiment of the present invention and a laser device 100 having the tunable laser 10. As illustrated in FIG. 2, the laser device 100 includes the tunable laser 10, a temperature control device 20, an output detection portion 30, a wavelength detection portion 40, and a controller 50. The tunable laser 10 is provided on the temperature control device 20. Next, a description will be given of details of each portion.

The tunable laser 10 has a structure in which a CSG-DBR region 11, a SG-DFB region 12 and a semiconductor optical amplifier (SOA: Semiconductor Optical Amplifier) region 13 are coupled in order.

The CSG-DBR region 11 includes an optical waveguide having a plurality of segments in which a first region having diffractive gratings and a second region coupled to the first region and acting as a space region. The optical waveguide is made of a semiconductor crystal having an absorption edge wavelength shorter than a laser oscillation waveguide. In the CSG-DBR region 11, each of the second regions has a different length. Heaters 14a to 14c are provided on a surface of the CSG-DBR region 11 along the optical waveguide. The CSG-DBR region 11 has a periodical peak in wavelength characteristics only in a limited wavelength range.

The SG-DFB region 12 includes an optical waveguide having a plurality of segments in which a first region having diffractive gratings and a second region coupled to the first region and acting as a space region. The optical waveguide is made of a semiconductor crystal having a gain with respect to a laser oscillation at a desired wavelength. In the SG-DFB region 12, each of the second regions has the same length. An electrode 15 is provided on the SG-DFB region 12. The SG-DFB region 12 has a periodical peak in wavelength characteristics. In the embodiment, peaks of gain spectrum are periodically distributed in the SG-DFB region 12.

The CSG-DBR region 11 and the SG-DFB region 12 have a peak in wavelength characteristics with a period different from each other, and act as a wavelength selection portion. A vernier effect is obtained when wavelength characteristics of the CSG-DBR region 11 and the SG-DFB region 12 are changed. That is, a wavelength at which intensity is the largest is selected from wavelengths at which the peaks are overlapped with each other.

The SOA region 13 includes an optical waveguide made of a semiconductor crystal for giving a gain to light or absorbing light with current control or voltage control. An electrode 16 is provided on the SOA region 13. Each optical waveguide of the CSG-DBR region 11, the SG-DFB region 12 and the SOA region 13 is optically connected to each other.

The tunable laser 10 is provided on the temperature control device 20. A thermistor (not illustrated) for measuring temperature of the temperature control device 20 is provided on the temperature control device 20.

The output detection portion 30 includes a receiving element for measuring intensity of a laser output light having passed through the SOA region 13. The wavelength detection portion 40 includes one receiving element for measuring intensity of the laser output light and another receiving element for measuring the laser output light including wavelength characteristics by having passed through an etalon. In FIG. 2, the wavelength detection portion 40 is arranged on the CSG-DBR region 11 side, and the output detection portion 30 is arranged on the SOA region 13 side. However, a structure is not limited to the above structure. For example, each detection portion may be arranged reverse.

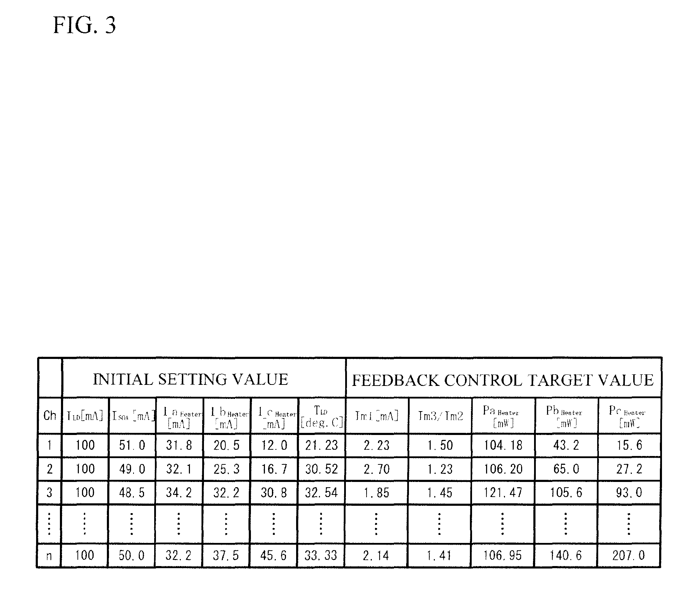

The controller 50 includes a control portion and a power supply. The control portion includes a CPU (Central Processing Unit), a RAM (Random Access Memory), and a ROM (Read Only Memory). The ROM of the controller 50 stores control information, a control program and so on of the tunable laser 10. The control information is, for example, recorded in a look-up table 51. FIG. 3 illustrates an example of the look-up table 51.

As illustrated in FIG. 3, the look-up table 51 includes an initial setting value and a feedback control target value with respect to each channel. The initial setting value includes an initial current value I_{LD} of the SG-DFB region 12, an initial current value I_{SOA} of the SOA region 13, an initial current value Ia_{Heater} to Ic_{Heater} of the heaters 14a to 14c, and an initial temperature T_{LD} of the temperature control device 20. The feedback control target value includes a feedback control target value Im1 of the output detection portion 30, a feedback control target value Im3/Im2 of the wavelength detection portion 40, and a feedback control target values Pa_{Heater} to Pc_{Heater} of electrical powers of the heaters 14a to 14c. The feedback control target value Im1 indicates a target value of the receiving element of the output detection portion 30. The feedback control target value Im3/Im2 indicates a target value of a ratio of the two receiving elements of the wavelength detection portion 40.

Next, a description will be given of an operation of the laser device 100 when starting. The controller 50 references the look-up table 51, and gets the initial current value I_{LD}, the initial current value I_{SOA}, the initial values Ia_{Heater} to Ic_{Heater} and the initial temperature value T_{LD} with respect to a set channel.

Next, the controller 50 controls the temperature control device 20 so that the temperature of the temperature control device 20 gets to the initial temperature value T_{LD}. Thereby, the temperature of the tunable laser 10 is controlled to be a constant value around the initial temperature value T_{LD}. Accordingly, an equivalent refractive index of the optical waveguide in the SG-DFB region 12 is controlled. Next, the controller 50 provides a current of the initial current value I_{LD} to the electrode 15. Then, the optical waveguide in the SG-DFB region 12 generates a light. Accordingly, the light generated in the SG-DFB region 12 is repeatedly reflected and amplified in the optical waveguide in the SG-DFB region 12. This allows a laser oscillation.

Next, the controller 50 provides currents of the initial current values Ia_{Heater} to Ic_{Heater} to the heaters 14a to 14c respectively. Therefore, the equivalent refractive index of the optical waveguide in the CSG-DBR region 11 is controlled to be a given value. Then, the controller 50 provides a current of the initial current value I_{SOA} to the electrode 16. With the controls, the tunable laser 10 emits a laser light at an initial wavelength of the set channel.

The controller 50 controls the current or the voltage provided to the SOA region 13 by feedback so that the detection result of the receiving element of the output detection portion 30 gets to the feedback control target value Im1. Therefore, the intensity of the laser light is controlled to be in a predetermined range.

The controller 50 controls the temperature of the temperature control device 20 by feedback so that a ratio of the detection values of the two receiving elements of the wavelength detection portion 40 gets to the feedback control target value Im3/Im2. Therefore, the oscillation wavelength is controlled to be in a predetermined range.

The controller 50 controls the electrical powers provided to the heaters 14a to 14c to be the feedback control target values Pa_{Heater} to Pc_{Heater} by feedback. With the operations, the tunable laser 10 oscillates at a desirable wavelength.

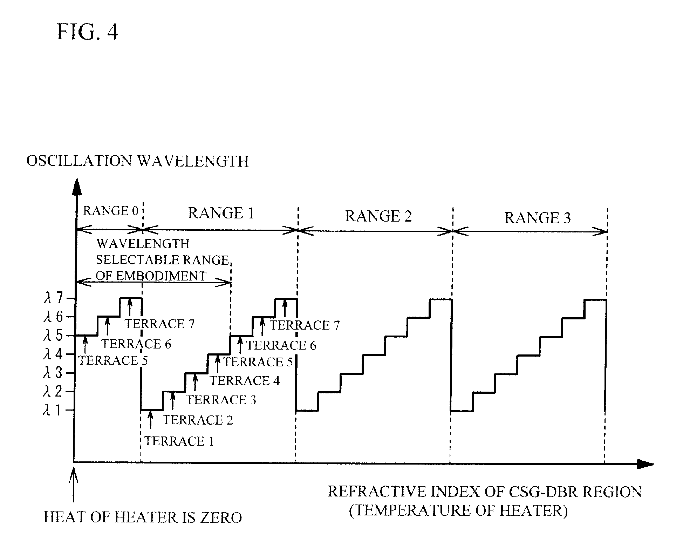

Next, a description will be given of a making process of the initial current values Ia_{Heter} to Ic_{Heater} of the look-up table 51. FIG. 4 illustrates an oscillation wavelength with respect to the refractive index changing of the CSG-DBR region 11, like FIG. 1. In the embodiment, the refractive index of the CSG-DBR region 11 is controlled with the temperature of the heaters 14a to 14c. In the embodiment, there are provided three heaters. FIG. 4 illustrates a case where each of the heaters has the same temperature.

For example, FIG. 4 illustrates a case where a wavelength λ5 at a range "0" is selected as an oscillation wavelength of the tunable laser 10 when no electrical power is provided to the heaters 14a to 14c (when generated heat is zero). In this case, the oscillation wavelength in a case where the heater temperature is the lowest is not λ1.

In general, the initial setting values Ia_{Heater} to Ic_{Heater} are made so that the λ1 to λ7 of the range 1 are selected as an oscillation wavelength. In the embodiment, however, the initial setting values Ia_{Heater} to Ic_{Heater} are made so that the oscillation wavelength is selected from an extent over adjacent two ranges. The initial setting values Ia_{Heater} to Ic_{Heater} are made so that a wavelength range from the λ5 of the range 0 to the λ4 of the range 1 is, for example, a wavelength selectable range.

In this case, the electrical power consumption of the heaters is the same as a case where the range 1 is selected as the wavelength selectable range, when the λ1 is used as the oscillation wavelength. However, the electrical power consumption of the heaters 14a to 14c may be reduced because the range 0 is used, when the λ5 to λ7 are used as the oscillation wavelength. Therefore, the temperature of the heaters 14a to 14c may be reduced, compared to a case where the λ1 to λ7 of the range 1 are used. Accordingly, the electrical power consumption of the heaters 14a to 14c may be reduced. A selectable oscillation wavelength is the same even if the oscillation wavelength is selected from an extent over the range 0 and the range 1 or even if the λ1 to λ7 of the range 1 are used. A required setting value may be obtained speedily when the initial setting values Ia_{Heater} to Ic_{Heater} of the embodiment are stored in the look-up table 51 with respect to every desired wavelength in advance.

The wavelength characteristics of FIG. 4 is obtained when the oscillation wavelength is measured at high accuracy with a wavelength meter in a condition that the electrical power provided to the heaters 14a to 14c are changed and the refractive index of the CSG-DBR region 11 is changed. It is preferable that the wavelength characteristics are obtained in the shipping test of the laser device 100.

In the embodiment, the wavelength selectable range is separated at the λ5 of the range 0. However, the wavelength selectable range is not limited to the case. The wavelength selectable range may be separated at the adjacent λ6 when an oscillation at the λ5 is not stable. In this case, the wavelength selectable range is from the λ6 of the range 0 to the λ5 of the range 1. The wavelength selectable range may be from the λ3 of the range 1 to the λ2 of the range 2 when the λ1 and the λ2 of the range 1 cannot be used. In this case, the electrical power consumption of the heaters 14a to 14c may be reduced because it is not necessary to use the λ3 to the λ7 of the range 2.

The above description is a case where the refractive index of the CSG-DBR region 11 is changed equally. However, the regions according to each heater in the CSG-DBR region 11 may be controlled separately when the heaters are provided separately. In this case, the selectable wavelength shifts toward longer wavelength side or shorter wavelength side from the selectable wavelength illustrated in FIG. 4, when the average temperature of the heaters are kept constant and temperature of the heaters is different from each other.

In order to make a wide wavelength selectable range in the tunable laser 10, the selectable wavelength is shift when the temperature of the CSG-DBR region 11 differs partially in addition to the overall changing of the temperature of the CSG-DBR region 11. In this case, the electrical power consumption of the heaters may be reduced when the oscillation wavelength is selected from an extent over adjacent two ranges.

In the above description, the heaters are used as a refractive index control portion of the CSG-DBR region 11. However, the structure is not limited to the above one. For example, the refractive index may be changed by injecting current to the CSG-DBR region 11. In this case, the injected current may be reduced when the oscillation wavelength is selected from an extent over adjacent two ranges.

In the embodiment, the SG-DBR region 12 acts as a first wavelength selection portion and acts as a gain region, the CSG-DBR region 11 acts as a second wavelength selection portion, the controller 50 acts as a storing portion, and the tunable laser 10 acts as a resonator.

### (Second Embodiment)

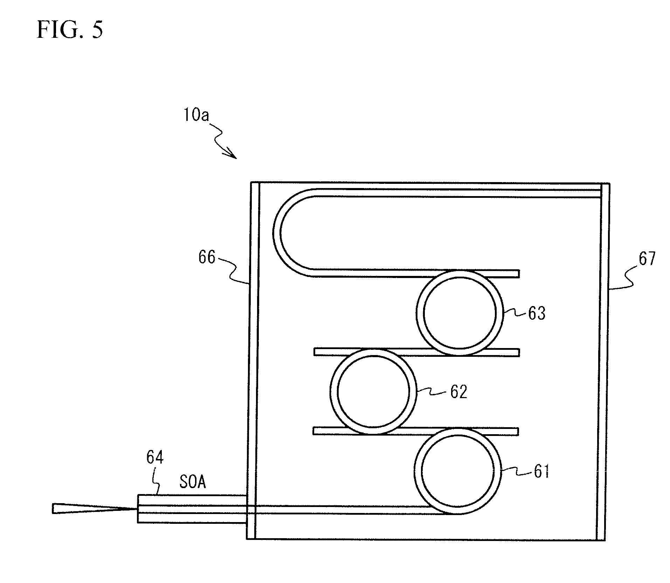

FIG. 5 illustrates a schematic view of a tunable laser 10a in accordance with a second embodiment of the present invention. The tunable laser 10a is a ring resonator type laser. As illustrated in FIG. 5, the tunable laser 10a has ring resonators 61, 62 and 63 optically coupled to each other and a SOA region 64 optically coupled to the ring resonators 61, 62 and 63. The ring resonator 61, the ring resonator 62 and the ring resonator 63 are optically coupled in order from the SOA region 64 side. An AR (Anti Reflection) film 66 is formed on an edge face on the ring resonator 61 side. A HR (High Reflection) film 67 is formed on an edge face on the ring resonator 63 side.

The ring resonator 61 is a resonator having periodical peaks in wavelength characteristics, and acts as a filter having a peak in reflection spectrum periodically at a given wavelength interval. The ring resonator 61 has the same wavelength characteristics as the SG-DFB region 12 of the tunable laser 10 in accordance with the first embodiment and determines the oscillation wavelength of the tunable laser 10a.

The ring resonators 62 and 63 are a resonator having periodical peaks in wavelength characteristics, and acts as a filter having a peak in reflection spectrum periodically at a given wavelength interval. Both of the ring resonators 62 and 63 have a diameter different from that of the ring resonator 61. The ring resonator 62 has a diameter different from that of the resonator 63. The ring resonators 62 and 63 make the periodical peaks in reflection spectrum only in a limited wavelength range. Therefore, the ring resonators 62 and 63 have the same wavelength characteristics as that of the CSG-DBR region 11 of the tunable laser 10a.

The ring resonators 62 and 63 respectively have a heater (not illustrated) on or under a ring thereof. Each of the heaters controls a refractive index of the ring resonators 62 and 63. Therefore, the oscillation wavelength of the tunable laser 10a can be controlled, when the temperature of each of the heaters is controlled.

The tunable laser 10a generates a vernier effect by overlapping a peak of the reflection spectrum of the ring resonator 61 and a peak of the reflection spectrum of the ring resonators 62 and 63. Thus, an oscillation wavelength is selected. The SOA region 64 is a semiconductor optical amplifier giving a gain to the resonators.

The wavelength characteristics illustrated in FIG. 4 appears in the tunable laser 10a in accordance with the embodiment, too. Therefore, the electrical power consumption of the heater can be restrained by selecting an oscillation wavelength from an extent over two adjacent ranges.

In the embodiment, the ring resonator 61 acts as a first wavelength selection portion, the ring resonators 62 and 63 act as a second wavelength selection portion, and the tunable laser 10a acts as a resonator.

### (Third Embodiment)

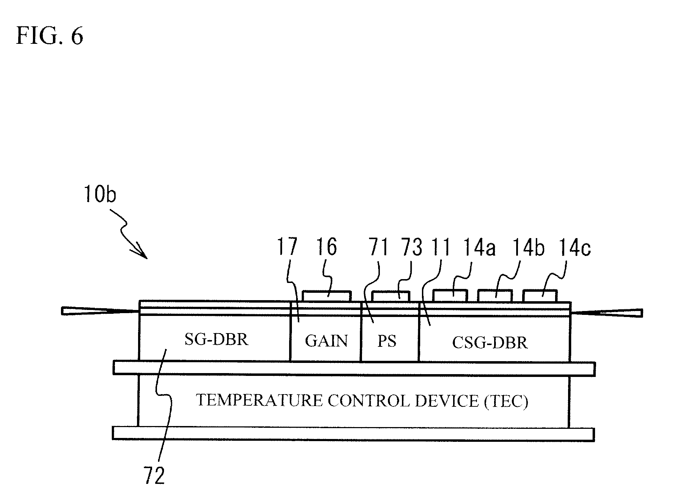

FIG. 6 illustrates a schematic view of a tunable laser in accordance with a third embodiment of the present invention. A tunable laser 10b has a structure in which the CSG-DBR region 11, a PS (Phase Shift) region 71, a gain region 17 and a SG-DBR (Sampled Grating Reflector) region 72 are coupled in order. An electrode 73 is provided on the PS region 71. The PS region 71 is a phase shift portion for controlling a longitudinal mode.

The PS region 71 is a phase shift portion for controlling the longitudinal mode based on an electrical signal provided to the electrode 73. The SG-DBR region 72 includes an optical waveguide having a plurality of segments in which a first region having diffractive gratings and a second region coupled to the first region and acting as a space region. The optical waveguide is made of a semiconductor crystal having an absorption edge wavelength shorter than the laser oscillation wavelength. In the SG-DBR region 72, each of the second areas has the same length. The SG-DBR region 72 has a periodical peak in wavelength characteristics and has a periodical peak in reflection spectrum.

In the embodiment, the gain region 17, the PS region 71 and the SG-DBR region 72 correspond to the SG-DFB region 12 in FIG. 2. The CSG-DBR region 11 and the SG-DBR region 72 have a peak in the wavelength characteristics at a different period and act as a wavelength selection portion. The vernier effect is obtained when the wavelength characteristics of the CSG-DBR region 11 and the SG-DBR region 72 is changed. That is, a wavelength having the largest intensity is selected from wavelengths where the peaks overlap with each other.

In the tunable laser 10b, the wavelength characteristics illustrated in FIG. 4 appears. Therefore, the electrical power consumption of the heaters 14a to 14c can be restrained by selecting an oscillation wavelength from a range over two adjacent ranges.

In the embodiment, the gain region 17 acts as a gain portion, the SG-DBR region 72 acts as a first wavelength selection portion, and the tunable laser 10b acts as a resonator.

## Claims

1. A laser device **characterized by** comprising:
a resonator having a gain region, a first wavelength selection portion and a second wavelength selection portion, the first wavelength selection portion having a periodical peak in wavelength characteristics, the second wavelength selection portion having a periodical peak in wavelength characteristics in a wavelength range smaller than a variable range of an oscillation wavelength at a period different from the first wavelength selection portion and having a peak wavelength shift by a refractive index changing thereof, the oscillation wavelength selected with a single direction changing of a refractive index of the second wavelength selection portion changing in a single direction in a same wavelength range;
a storing portion storing a value selected from an extent over two adjacent ranges of the plurality of the ranges as a setting value of a refractive index of the second wavelength selection portion for selecting an oscillation wavelength; and
a controller giving the setting value stored in the storing portion to the resonator.

2. The laser device as claimed in claim 1, **characterized in that** the storing portion stores a value selected within a range from an oscillation wavelength selected in a condition that the refractive of the second wavelength selection portion is not changed to a wavelength equal to the oscillation wavelength in the adjacent range.

3. The laser device as claimed in claim 1, **characterized in that** the storing portion stores a value selected within a range from an oscillation wavelength adjacent to another oscillation wavelength selected in a condition that the refractive of the second wavelength selection portion is not changed to a wavelength equal to the another oscillation wavelength in the adjacent range.

4. The laser device as claimed in claim 1, **characterized in that** a setting value of a refractive index of the second wavelength selection portion is temperature of the second wavelength selection portion or current provided to the second wavelength selection portion.

5. The laser device as claimed in any of claims 1 to 4, **characterized in that** the storing portion stores a setting value of a refractive index of the second wavelength selection portion with respect to each desired wavelength.

6. A laser device control data of a laser device having a gain region, a first wavelength selection portion and a second wavelength selection portion, the first wavelength selection portion having a periodical peak in wavelength characteristics, the second wavelength selection portion having a periodical peak in wavelength characteristics in a wavelength range smaller than a variable range of an oscillation wavelength at a period different from the first wavelength selection portion and having a peak wavelength shift by a refractive index changing thereof, the oscillation wavelength selected with a single direction changing of a refractive index of the second wavelength selection portion changing in a single direction in a same wavelength range,
**characterized in that** the laser device control data includes a setting value for determining a refractive index of the second wavelength selection portion according to an oscillation wavelength to be attained so that an extent from a maximum of the refractive index to a minimum of the refractive index is over the plurality of the ranges.

7. The laser device control data as claimed in claim 6, **characterized in that** a setting value of a refractive index of the second wavelength selection portion is temperature of the second wavelength selection portion or current provided to the second wavelength selection portion.
